(19) Europäisches Patentamt / European Patent Office / Office européen des brevets

(11) **EP 1 841 057 B1**

(12) **EUROPEAN PATENT SPECIFICATION**

(45) Date of publication and mention
of the grant of the patent:
**21.10.2009 Bulletin 2009/43**

(51) Int Cl.:
***H03B 5/12*** *(2006.01)*

(21) Application number: **06111773.5**

(22) Date of filing: **27.03.2006**

(54) **Power efficient single-pin harmonic oscillator with complementary active devices**

Leistungseffizienter harmonischer Oszillator mit komplementären aktiven Bauteilen und einem einzigen Verbindungsstift

Oscillateur harmonique efficace en puissance utilisant des dispositifs complémentaires et une seule broche

(84) Designated Contracting States:
**AT DE FR IT NL**

(43) Date of publication of application:
**03.10.2007 Bulletin 2007/40**

(73) Proprietor: **ELMOS Semiconductor AG**
**44227 Dortmund (DE)**

(72) Inventor: **Eikenbroek, Jan-Wim**
**7827 EE Emmen (NL)**

(74) Representative: **Hilleringmann, Jochen**
**Patentanwälte**
**Von Kreisler-Selting-Werner,**
**Bahnhofsvorplatz 1 (Deichmannhaus am Dom)**
**50667 Köln (DE)**

(56) References cited:
EP-A- 0 948 127          US-A- 3 475 698
US-A- 3 855 552          US-A- 4 160 953

• HIRATA M ET AL: "NEW BIAS VOLTAGE
GENERATORS FOR TFT-LCD'S DRIVERS" IEICE
TRANSACTIONS ON ELECTRONICS,
ELECTRONICS SOCIETY, TOKYO, JP, vol. E83-
C, no. 10, October 2000 (2000-10), pages
1579-1583, XP000970177 ISSN: 0916-8524

**Description**

BACKGROUND OF THE INVENTION

Field of the Invention

The present invention relates to an oscillator, in particular for generating a carrier signal for wireless applications such as wireless transceivers. Specially, the present invention relates to a power efficient single-pin harmonic oscillator with complementary active devices without a bias current source for these active devices of the oscillator,

Related Prior Art

In many (wireless) applications a carrier signal must be generated A common approach to realise this is by means of a frequency synthesizer. In such a system, a voltage controlled oscillator (VCO) is required. The core of such a VCO is an oscillator. In very low power applications it is attractive to use the oscillator output-signal directly to feed the antenna, so that no RF power amplifier is required anymore. Such an oscillator is called a "power oscillator".

In addition, when an external inductor is used for the resonator-circuit of such an oscillator, the power consumption of the oscillator can be reduced compared to its counterpart with an integrated inductor. The reason for this is that the quality factor Q of an external coil is usually much higher than the Q of an integrated inductor while the bias current of the oscillator is inversely proportional to the Q of the resonator.

Another important issue is the number of pins that are required for an oscillator with an external coil.

US-A-4,160 953 describes a self-oscillation mixer circuit including a cascade amplifier circuitry which is composed of a first transistor of a common emitter connection having a collector connected to an emitter of a second transistor of a common base connection, a filter circuitry for deriving an intermediate frequency signal and a resonance circuit adapted to resonate at a local oscillation frequency being connected to the collector of the second transistor and a feedback circuitry connected between the resonance circuitry and the emitter of the first transistor. This circuit can also employ complementary transistors.

US-A-3,855,552 discloses an oscillator constructed using complementary transistors in a push-pull configuration employs means to vary at least one base voltage divider resistor to adjust the working points of the complementary transistors and an additional transistor having its emitter-collector circuit connected between the bases of the complementary transistors, which additional transistor has its conduction controlled by the output signal of the oscillator so that the collector-emitter region thereof is progressively driven toward lower and lower resistance in response to increasing amplitude of oscillation.

This invention deals with oscillators that require a single pin to connect the active part with the (internal or external) coil (this are so called "single-pin oscillators"). It is to be noted that only oscillators which require only one inductor and where the amplifying-part and the inductor share only one common pin are considered here.

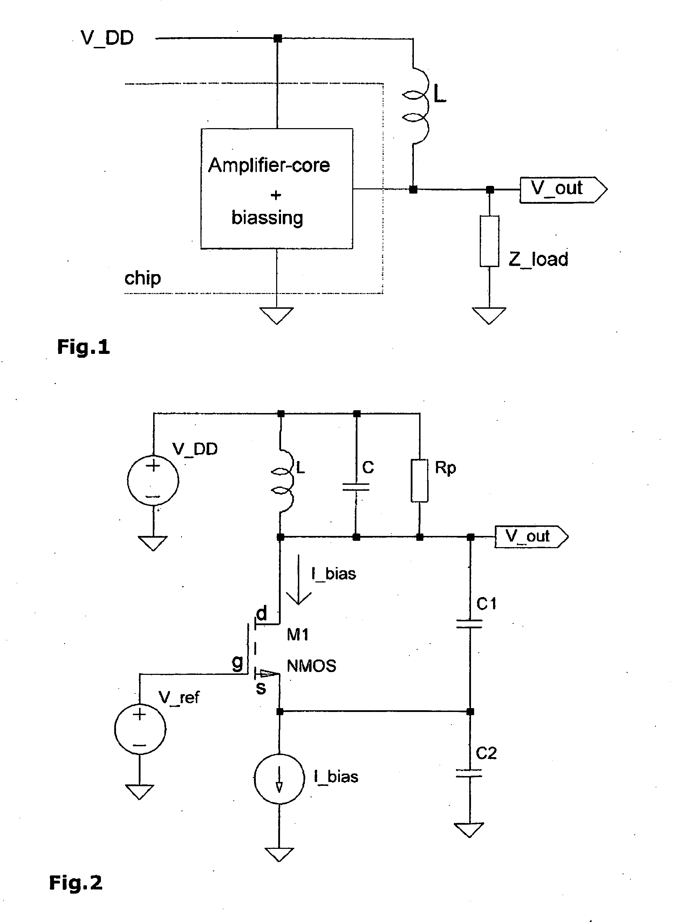

In Fig. 1 the main components and units of a known single-pin oscillator with an external inductor is shown schematically. But this invention is applicable to oscillators with an integrated or internal coil as well.

A common known power oscillator configuration with one coil is shown in Fig. 2. It is a Colpitts oscillator [ref. 1] and it is one example of the 3-pins oscillator family. Because the invention deals with oscillators that require a single inductor, the representative of the prior art oscillators will be called "Colpitts oscillator" hereafter for convenience.

Fig. 2 shows a realisation with an NMOS device, but to those skilled in the art, it will be obvious that a realisation with a PMOS device or a bipolar device is equally possible.

In all these realisations, an amplifier transistor and a current source are connected in series between the supply-voltage and ground, which sets a minimum to the lowest possible power-supply because all active devices require a certain minimum voltage-drop between their terminals in order to act as amplifying devices.

The goal is to maximise the power efficiency of the oscillator (we should aim at maximising the conversion of bias power to RF output signal power)

First of all, start-up must be ensured: the small signal loopgain $A\beta_{ss}$ must be larger than 1 under all conditions. Usually, a small-signal loopgain of more than 2 is sufficient The loopgain is given by (see [ref. 1], [ref. 2] and the appendix):

$$A\beta_{ss} \approx g_m R_p \left(n - n^2\right) > 1$$

where $g_m$ = the small-signal transconductance of the gain transistor (M1 in Fig. 2), while $R_p$ = the total loss resistance of the tank circuit and n = the capacitive tap ratio $C_1/(C_1 + C_2)$ (see Fig. 2).

The maximum loopgain for a given bias-current is obtained when $C_1 = C_2$, so n=0.5. However, for other reasons, like optimum phasenoise performance [ref. 1], a tap ratio between 0,5 and 0.2 is also quite common.

The output-power can be increased by increasing the bias current until one of the transistors enters its linear region during a part of the oscillation period Ultimately, the voltage swing at the output (= drain) of the oscillator is limited by the level where one of the transistors enters its linear region. For the Colpitts oscillator, either the gain transistor can enter its linear region or the transistor of the current source can run into its linear region. The maximum voltage swing is obtained when both transistors enter their linear region simultaneously. The corresponding (maximum) peak voltage swing is $V_{o-peak} = V_{DD}-2V_{DS-sat}$

When the maximum output voltage is reached, the required signal current at the oscillation frequency is given by the ratio of the voltage swing and the resistance across the inductor

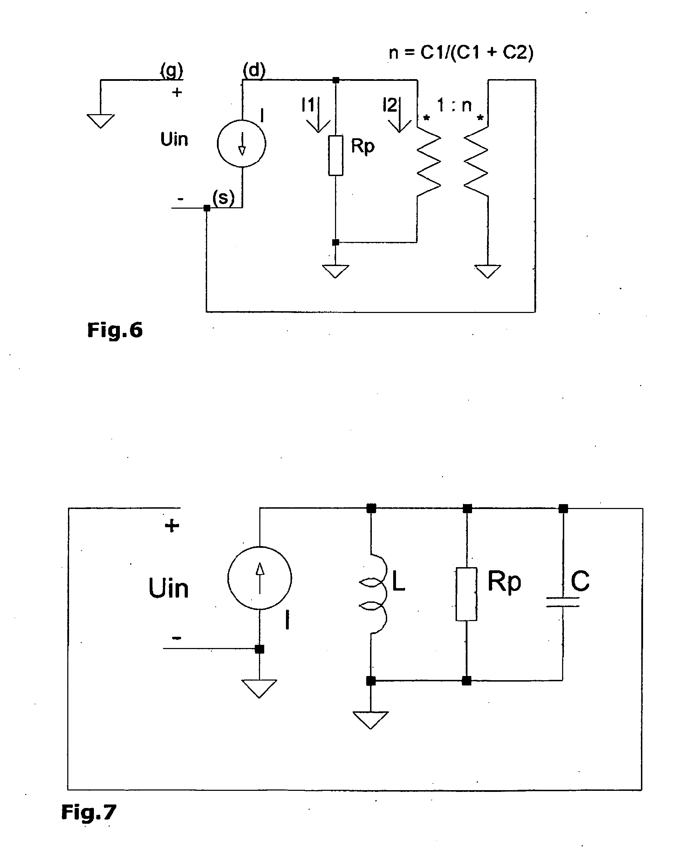

The total resistance at the output node is (see Fig. 6):

$$R_{tot} = (1-n)R_p$$

The reason why $R_{tot}$ is less than $R_p$ is because the transformed low input resistance of the amplifying device is present across the inductor via the capacitive tap.

When during oscillation the peak-value of the sinusoidal RF voltage across the inductor is $U_p$, the associated peak-current is:

$$I_p = \frac{U_p}{(1-n)R_p}$$

The total root mean square (RMS) RF power generated across the tank-circuit is

$$P_{rf} = \frac{1}{2}I_p U_p = \frac{0.5U_p^2}{(1-n)R_p}$$

However, the RMS RF power dissipated by $R_p$ is given by

$$P_{Rp} = \frac{0.5U_p^2}{R_p}$$

So, only a part of the RF power can be used in such an oscillator. The ratio of useful power and total RF power is

$$\frac{P_{Rp}}{P_{rf}} = (1-n)$$

Because in practice $0.2 < n < 0.5$ is used, at least 20% of the RF power is wasted.

Accordingly, there is a need for a more efficient single-pin oscillator which uses less power compared to known oscillators.

SUMMARY OF THE INVENTION

The present invention provides an oscillator for generating a carrier signal for wireless applications the oscillator comprising the features of claim 1.

The oscillator of the present invention comprises a resonance circuit formed as an LC circuit having an inductor which can be an internal or external coil or the like inductor. An amplifier circuit is connected to the resonance circuit with the circuit node between the resonance circuit and the amplifier establishing an output terminal of the resonator. The output terminal is coupled to the amplifier circuit by a DC block capacitor.

According to the invention, the amplifier circuit is built like a differential amplifier formed by complementary transistor devices with the first transistor device connected to the resonance circuit and the second transistor device connector to the first transistor device. The resonance circuit and the first transistor device, and the second transistor device are connected in series and a supply voltage can be applied thereto. The DC block capacitor is connected to the control input of the second transistor.

In one embodiment of the invention the control inputs of the first and second transistors are provided with bias reference voltages wherein a bias resistor may be connected between the control input of the second transistor and a ground potential. The bias voltage for the first transistor can for instance be derived by means of a voltage divider connected to the supply voltage.

The core of the invention can be seen in the use of complementary transistor devices as an amplifier for the oscillator. The complementary transistors can be MOS or bipolar transistors of other complementary active semiconductor devices.

In order to improve the efficiency of the oscillator, by way of the invention an alternative to the Colpitts type of oscillators was sought The drawback of the Colpitts type oscillators is that these oscillators load the resonator tank, due to the inherent low input-impedance of the amplifier-transistor. Preferable, a gate-terminal (or base-terminal) should be the input terminal of the amplifying device. But in order to construct a positive feedback loop, another active element is required In addition, the peak output-current should not be limited by the presence of a current-source.

A much better power efficiency is realised by the new oscillator compared to the Colpitts type of oscillator due to the higher parallel resistance of the resonator at the oscillating frequency. This means that less average supply current is required for the same output power.

BRIEF DESCRIPTION OF THE DRAWINGS

The present invention will be explained in more detail referring hereinbelow to specific embodiments shown in the drawings in which

Fig. 1        is a schematic drawing of the main components and units of a single-pin oscillator,

Fig. 2        is the circuitry of a known single-pin oscillator (called Colpitts oscillator),

Fig. 3        is an embodiment of an oscillator according to the invention,

Fig. 4        is a circuit showing the embodiment according to Fig. 3 combined with a chargepump for biasing one of its complementary transistor devices, and

Figs. 5 to 7   are drawings for explaining loopgain calculations of a Colpitts oscillator versus that of the oscillator according to the invention.

DETAILED DESCRIPTION OF PREFERRED EMBODIMENTS

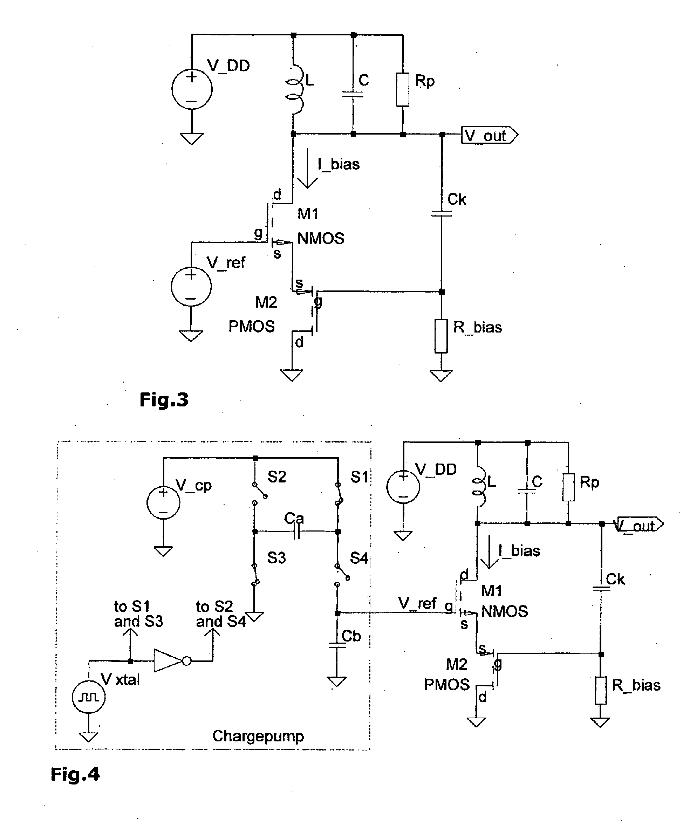

A basic version of an alternative solution that fulfils all requirements is shown in Fig. 3.

Note that for those skilled in the art, a version of the oscillator with the inductor referenced to ground is easily constructed

Although a version consisting of a NMOS and a PMOS device is shown in Fig. 3, it must be emphasized that the oscillator can be constructed with any two complementary active devices.

Compared with the Colpitts oscillator, in Fig. 3 the current source of the Colpitts oscillator is replaced by a PMOS transistor. In fact, the active part in Fig. 3 is simply a differential pair where one of the transistors is replaced by a complementary device Because of the use of complementary devices, the tail-current source which is required to bias the transistors of a standard differential-pair is no longer required Here, biasing is accomplished by means of the reference voltage-source V_ref which provides the gate-source bias-voltages of the transistors, while the gate-resistor R_bias ties the gate of M2 to ground for DC. R_bias is a high ohmic resistor in order to avoid to influence the signal-behaviour of the oscillator.

Due to the absence of a bias current-source, the signal voltage between the two gates can become very large and, consequently, a very large drain current will be induced. These current peaks are not bounded by a current-source (which is the case in the previously described known oscillator)

In addition, the capacitive voltage divider of the Colpitts oscillator (which attenuates the signal-voltage) is replaced by a coupling capacitor Ck, which only serves as a DC block between the output-node and the input-node of the amplifying-core. The value of Ck must be chosen such that the signal voltage-drop is minimal.

Start up of the oscillation is ensured when the small-signal loopgain is larger than one. The small signal loopgain is given by (see the appendix):

$$A\beta_{ss} \approx \frac{R}{\left(\dfrac{1}{g_{mN}} + \dfrac{1}{g_{mP}}\right)} > 1$$

where $g_m$ is the transconductance of the complementary transistors. Usually, both transconductances will be made equal

Again, the maximum voltage swing is limited by the sum of the saturation voltages of the two transistors So, $U_{o\text{-}peak} = V_{DD} - U_{DS\text{-}satN} + U_{DS\text{-}satP}$.

The maximum voltage swing across the load is (assuming $U_{DS\text{-}sat}$ is equal for both transistors)

$$U_{o\text{-}peak} = V_{DD} - 2\left|U_{DS\text{-}sat}\right|$$

The total resistance at the output node at the oscillation frequency is

$$R_{tot} \approx R_p$$

When during oscillation a certain sinusoidal RF voltage with peak-value Up is present across the inductor, the associated peak-current is:

$$I_p = \frac{U_p}{R_p}$$

The RMS RF power dissipated by Rp is simply given by

$$P_{Rp} = \frac{1}{2} I_{Rp} U_{Rp} = \frac{0.5 U_p^2}{R_p}$$

This is also the total generated RF power across the tank-circuit. So, no power is lost in this oscillator circuit, compared to the previously described oscillator circuit.

It is to be noted that this in practice implies that a 20% to 50% improvement in efficiency can be obtained by the new oscillator,

Moreover, when regarding the required current-drain from the battery in order to realise a certain RF output-power for both oscillators, this current drain will be less for the oscillator with the complementary devices compared to the required current drain of the Colpitts oscillator.

Note that for the new oscillator, the bias current must be set by a proper choice of the reference voltage at the gate of the common-gate transistor (see Fig. 3).

Low-voltage application:

When the supply-voltage $V_{DD}$ is close to the sum of the gate-source bias voltages of the complementary devices, it may happen that the voltage-difference between the supply-voltage $V_{DD}$ and the reference voltage $V_{ref}$ is not sufficient to implement the reference voltage circuitry. In that case, a voltage multiplier ("chargepump") can be used. Because this voltage multiplier does not have to provide a lot of current (its output is connected to a control input of an active device), the power efficiency of such a system can be made quite high. For such a voltage multiplier, a clock-signal is required. But in virtually all (wireless) systems a reference oscillator is present which can be used for this voltage multiplier.

An example of the combination of a chargepump and the new oscillator is shown in Fig. 4.

In Fig. 4, a digital signal ($V_{xtal}$) from a (crystal-) oscillator drives, via an inverter, the four switches S1, S2, S3 and S4. During the phase of a crystal oscillator period where S1 and S3 are closed, capacitor Ca is charged to a voltage $V_{cp}$, while during the other phase of the oscillator-period (S2 and S4 are closed), this charged capacitor is put in series with the chargepump voltage-source $V_{cp}$. So, in total (assuming a negligible load-current at the output of the chargepump) the output voltage of the chargepump is $2 \cdot V_{cp}$. The desired reference voltage at the gate of M1 can be obtained by choosing $V_{cp} = \frac{1}{2} V_{ref}$. Capacitor Cb acts as a voltage buffer.

1 Example calculations for a CMOS realisation

Suppose one want to design a Colpitts oscillator and a NMOS/PMOS oscillator with the same inductor. What are the advantages of the complementary device realisation?

Assumptions:

$$\text{Parallel resistance of the inductor losses} = R_p$$

Small-signal loopgain at start-up: $A\beta_0$ must be the same for both oscillators

Calculations:

For the Colpitts oscillator, the required $g_{mC}$ is:

$$g_{mC} = \frac{A\beta_0}{R_p\left(n - n^2\right)}$$

While, the overall $g_m$ for the complementary transistor oscillator must be

$$\frac{1}{\dfrac{1}{g_{mN}} + \dfrac{1}{g_{mP}}} = \frac{A\beta_0}{R_p}$$

When one use the same NMOS transistors and when one choose $g_{mP} = g_{mN}$, then the ratio of the transconductances of the two oscillators becomes:

$$\frac{g_{mN}}{g_{mC}} = 2\left(n - n^2\right)$$

So, for n=0.5, the required $g_m$ of the new oscillator can be 0.5 times the $g_m$ of the Colpitts oscillator. While for n=0.2 (which is more realistic in practice, see [ref. 1]), this factor becomes 0.32.

When one assume a quadratic relation between the drain-current and the gate overdrive voltage, the bias-current of the new oscillator can be between 0.1 and 0.25 times the bias-current of the Colpitts oscillator (depending on the value of n) for the same loopgain.

2 APPENDIX

In order to derive the loopgain of an oscillator, consider the controlled current-source of the active part as an independent current source with a value "I" and calculate the control-voltage ($U_{in}$) due to this independent current-source. The ratio $U_{in}/I$ is the feedback part ($\beta$) of the loopgain.

The gain-factor of the loopgain is the actual transconductance $G_m$ of the active part [Ref. 3].

a) Loopgain calculations of a 3 point oscillator (such as the Colpitts oscillator):

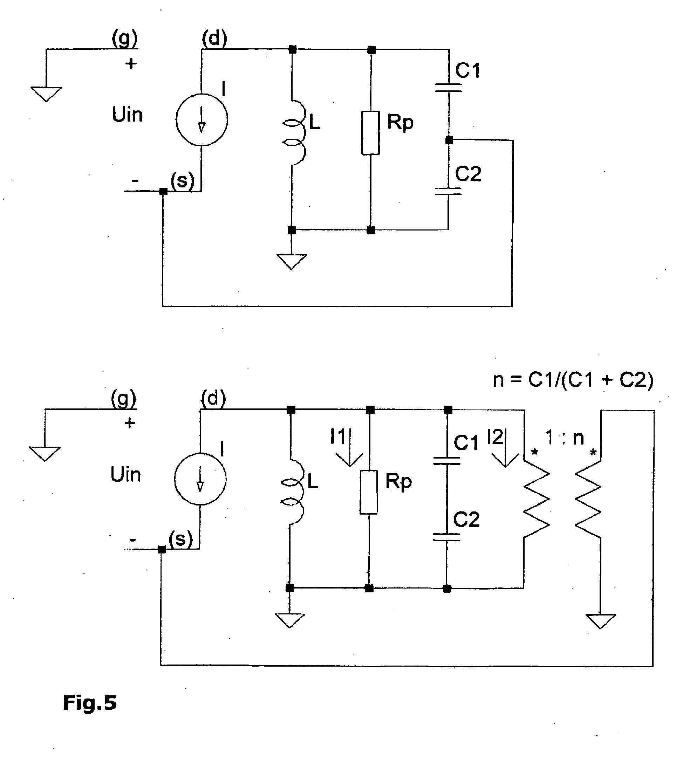

If one can consider the capacitive tap as an ideal transformer with a turns-ratio n, where n = C1/(C1+C2) (see Fig 5) one can construct the circuit as shown at the bottom of Fig. 5.

The following relations hold at resonance:

$$I = -(I_1 + I_2)$$

$$I_2 = n \cdot I$$

$$I_1 R_p = -\frac{U_{in}}{n}$$

So,

$$\beta = \frac{U_{in}}{I} = n(1-n)R_p$$

While the gain-factor of the active-part is:

$$A = G_m$$

The total loopgain at the oscillation frequency becomes:

$$A\beta = G_m R_p \left(n - n^2\right)$$

with

$$n = \frac{C_1}{C_1 + C_2}$$

b) Loopgain of the oscillator with complementary devices:

The small-signal equivalent circuit is shown in Fig. 7.

At the oscillation-frequency, the feedback factor is simply given by

$$\beta = \frac{U_{in}}{I} = R_p$$

While the gain-factor of the two complementary devices together is

$$A = \frac{1}{\left(\dfrac{1}{g_{mN}} + \dfrac{1}{g_{mP}}\right)}$$

The loopgain $A\beta$ of the complementary transistor oscillator becomes:

$$A\beta = \frac{R_p}{\left(\dfrac{1}{g_{mN}} + \dfrac{1}{g_{mP}}\right)}$$

References

[1] Thomas H. Lee, The Design of CMOS Radio-Frequency Integrated Circuits, 2-nd edition, Cambridge University Press, 2004, ISBN 0 521 83539 9.

[2] Behzad Razavi, Design of Analog CMOS Integrated Circuits, McGraw-Hill, 2001, ISBN 0-07-238032-2.

[3] E.H. Nordholt, The Design of High-Performance Negative-Feedback Amplifiers, Amsterdam, Elsevier Scientific Publishing Company, 1983.

**Claims**

1. Oscillator for generating a carrier signal for wireless applications comprising

   - a resonance circuit including an inductor (L),
   - an amplifier circuit connected to the resonance circuit, and
   - an output terminal (V_out) connected to the circuit node between the resonance circuit and the amplifier and for outputting an oscillating voltage signal,
   - wherein the amplifier comprises two complementary transistor devices (NMOS, PMOS), including a first transistor device (NMOS) and a complementary second transistor device (PMOS) each having a controllable current path,
   - wherein the first transistor device (NMOS) is connected to the resonance circuit and the complementary second transistor device (PMOS) is connected in series to the first transistor device (NMOS),
   - wherein a capacitor (Ck) is connected between the output terminal (V_out) and the control input of a second transistor device (PMOS) **characterised in that** the resonance circuit and the current paths of the first and second transistor devices are arranged in series to each other between a first electrical potential and a second electrical potential.

2. Oscillator according to claim 1, wherein reference bias voltages are applied to the control inputs of the first and second transistor devices (NMOS, PMOS).

3. Oscillator according to claim 2, wherein a charge pump is used for biasing the control input of the first transistor (NMOS).

4. Oscillator according to any one of claims 1 to 3, wherein a first electrical potential (V_DD) is connected to the resonance circuit with the complementary transistor devices (NMOS, PMOS) connected between the resonance circuit and a second electrical potential.

5. Oscillator according to any one of claims 1 to 4, wherein a bias resistor (R_bias) is connected between the control input of the second transistor device (PMOS) and a ground potential.

6. Oscillator according to any one of claims 1 to 5, wherein the complementary first and second transistor devices (NMOS, PMOS) are MOS or bipolar transistors.

**Patentansprüche**

1. Oszillator zur Erzeugung eines Trägersignals für drahtlose Anwendungen, mit

- einer einen Induktor (L) aufweisenden Resonanzschaltung,
- einer mit der Resonanzschaltung verbundenen Verstärkerschaltung, und
- einem Ausgangsanschluss (V_out), welcher mit dem Schaltungsknoten zwischen der Resonanzschaltung und dem Verstärker verbunden ist und zum Ausgeben eines oszillierenden Spannungssignals vorgesehen ist,
- wobei der Verstärker zwei komplementäre Transistorvorrichtungen (NMOS, PMOS) aufweist, welche eine erste Transistorvorrichtung (NMOS) und eine komplementäre zweite Transistorvorrichtung (PMOS) umfassen, die jeweils einen steuerbaren Strompfad aufweisen,
- wobei die erste Transistorvorrichtung (NMOS) mit der Resonanzschaltung verbunden ist und die komplementäre zweite Transistorvorrichtung (PMOS) mit der ersten Transistorvorrichtung (NMOS) in Reihe verbunden ist,
- wobei ein Kondensator (Ck) zwischen dem Ausgangsanschluss (V_out) und dem Steuereingang einer zweiten Transistorvorrichtung (PMOS) verbunden ist,

**dadurch gekennzeichnet, dass** die Resonanzschaltung und die Strompfade der ersten und der zweiten Transistorvorrichtung in bezug zueinander in Reihe zwischen einem ersten elektrischen Potential und einem zweite elektrischen Potential angeordnet sind.

2. Oszillator nach Anspruch 1, bei dem Referenz-Vorspannungen an die Steuereingänge der ersten und der zweiten Transistorvorrichtung (NMOS, PMOS) angelegt werden.

3. Oszillator nach Anspruch 2, bei dem eine Ladungspumpe zum Vorspannen des Steuereingangs des ersten Transistors (NMOS) verwendet wird.

4. Oszillator nach einem der Ansprüche 1 bis 3, bei dem ein erstes elektrisches Potential (V_DD) mit der Resonanzschaltung verbunden ist, wobei die komplementären Transistorvorrichtungen (NMOS, PMOS) zwischen der Resonanzschaltung und einem zweiten elektrischen Potential verbunden sind.

5. Oszillator nach einem der Ansprüche 1 bis 4, bei dem ein Vorspannungswiderstand (R_bias) zwischen dem Steuereingang der zweiten Transistorvorrichtung (PMOS) und einem Massepotential verbundnen ist.

6. Oszillator nach einem der Ansprüche 1 bis 5, bei dem die komplementären ersten und zweiten Transistorvorrichtungen (NMOS, PMOS) MOS- oder Bipolartransistoren sind.

**Revendications**

1. Oscillateur pour la génération d'un signal porteur pour des applications sans fil, comprenant

- un circuit de résonance comprenant un inducteur (L),

- un circuit amplificateur raccordé au circuit de résonance, et
- un terminal de sortie (V_out) raccordé au noeud de circuit entre le circuit de résonance et l'amplificateur et pour faire sortir un signal de tension oscillant,
- l'amplificateur comprenant deux dispositifs transistors complémentaires (NMOS, PMOS), comprenant un premier dispositif transistor (NMOS) et un deuxième dispositif transistor (PMOS) complémentaire, chaque dispositif comprenant un chemin de courant contrôlable,
- le premier dispositif transistor (NMOS) étant raccordé au circuit de résonance et le deuxième dispositif transistor complémentaire (PMOS) étant raccordé en série audit premier dispositif transistor (NMOS),
- un condensateur (Ck) étant raccordé entre le terminal de sortie (V_out) et l'entrée de contrôle d'un deuxième dispositif transistor (PMOS),

**caractérisé en ce que** le circuit de résonance et le chemin de courant du premier et deuxième dispositif transistor sont disposés en série par rapport à eux entre un premier potentiel électrique et un deuxième potentiel électrique.

2. Oscillateur selon la revendication 1, dans lequel des tensions de biais de référence sont appliquées aux entrées de contrôle du premier et deuxième dispositif transistor (NMOS, PMOS).

3. Oscillateur selon la revendication 2, dans lequel une pompe de charge est utilisée pour le biais de l'entrée de contrôle du premier transistor (NMOS).

4. Oscillateur selon l'une quelconque des revendications 1 à 3, dans lequel un premier potentiel (V_DD) est raccordé au circuit de résonance, les dispositifs transistor complémentaires (NMOS, PMOS) étant raccordés entre le circuit de résonance et un deuxième potentiel électrique.

5. Oscillateur selon l'une quelconque des revendications 1 à 4, dans lequel une résistance de biais (R_bias) est raccordée entre l'entrée de contrôle du deuxième dispositif transistor (PMOS) et un potentiel de masse.

6. Oscillateur selon l'une quelconque des revendications 1 à 5, dans lequel le premier et le deuxième dispositif transistor complémentaire (NMOS. PMOS) sont des transistors à MOS ou bipolaires.

**Fig.1**

**Fig.2**

**Fig.3**

**Fig.4**

**Fig.5**

n = C1/(C1 + C2)

**Fig.6**

**Fig.7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4160953 A
- US 3855552 A

### Non-patent literature cited in the description

- **THOMAS H. LEE.** The Design of CMOS Radio-Frequency Integrated Circuits. Cambridge University Press, 2004
- **BEHZAD RAZAVI.** Design of Analog CMOS Integrated Circuits. McGraw-Hill, 2001
- **E.H. NORDHOLT.** The Design of High-Performance Negative-Feedback Amplifiers. Elsevier Scientific Publishing Company, 1983